**Europäisches Patentamt**

**European Patent Office**

**Office européen des brevets**

(11) Veröffentlichungsnummer: **0 071 233**
**B1**

(12) **EUROPÄISCHE PATENTSCHRIFT**

(45) Veröffentlichungstag der Patentschrift:
**11.05.88**

(21) Anmeldenummer: **82106750.1**

(22) Anmeldetag: **26.07.82**

(51) Int. Cl.⁴: **H 01 L 23/02**

(54) In einen Becher eingesetztes elektrisches Bauelement, Bauelementegruppe oder integrierte Schaltung.

(30) Priorität: **28.07.81 DE 3129756**

(43) Veröffentlichungstag der Anmeldung:
**09.02.83 Patentblatt 83/6**

(45) Bekanntmachung des Hinweises auf die Patenterteilung:
**11.05.88 Patentblatt 88/19**

(84) Benannte Vertragsstaaten:
**DE FR IT**

(56) Entgegenhaltungen:
**DE - A - 2 451 895**
**FR - A - 1 560 381**
**FR - A - 2 299 716**
**US - A - 4 233 620**

(73) Patentinhaber: **Siemens Aktiengesellschaft Berlin und München, Wittelsbacherplatz 2, D-8000 München 2 (DE)**

(72) Erfinder: **Pilz, Dieter, Dipl.-Ing., Zugspitzstrasse 6, D-8039 Puchheim (DE)**
Erfinder: **Wagmann, Walter, Haidgraben 93, D-8012 Ottobrunn (DE)**

ACTORUM AG

## Beschreibung

In einen Becher eingesetztes elektrisches Bauelement, Bauelementegruppe oder integrierte Schaltung.

Die Erfindung betrifft ein in einen Becher eingesetztes elektrisches Bauelement, eine Bauelementegruppe oder integrierte Schaltung, insbesondere ein elektrisches OFW-Filter, mit zur Becheraussenseite gekehrten elektrischen und mechanischen Anschlusselementen, die abschnittsweise in einem als Becherverschluss wirkenden Kunststoffteil gehalten sind, dessen zum Becher gekehrte Flächen mittels thermoplastischem Kunststoff staub- und feuchtigkeitsdicht mit dem Becher verbunden sind (siehe FR-A-1 560 381).

Elektronische Bauelemente, wie z.B. die vorstehend genannten Oberflächenwellenfilter, werden auf Trägerelemente aufgebaut, wobei das eigentliche Bauteil, z.B. der Chip auf dem Trägerelement befestigt wird und ein oder mehrere Anschlüsse des Chips mit Anschlüssen, die in ein Kunststoffteil des Trägerelements eingelassen sind, mittels metallischer Verbindungen, z.B. Drähten oder Bändchen galvanisch verbunden sind. Auf diese Weise entsteht ein funktionsfähiges elektronisches Bauelement mit Aussenanschlüssen, das jedoch gegenüber mechanischen und klimatischen Umwelteinflüssen ungeschützt ist. Gleiches gilt für Bauelementegruppen und integrierte Schaltungen.

Zum Schutz der elektronischen Bauelemente, Bauelementegruppen und integrierten Schaltungen wird i.a. eine Kappe oder ein Becher aus Kunststoff oder Metall verwendet, der das Bauteil umhüllt. Die Verbindung zwischen Kappe oder Becher und Trägerelement geschieht dabei mittels Kleber oder durch Vergiessen mit Kunstharz, z.B. Epoxidharz. Das Kunstharz bedeckt dabei die Oberseite des als Kappen- oder Becherverschluss dienenden Kunststoffteils und dringt in die Fuge zwischen Becher und Kunststoffteil ein.

Das Einführen des Kunstharzes oder Klebers ist jedoch insbesondere bei sehr kleinen Bauteilen schwierig, weshalb die Gefahr besteht, dass die nach aussen führenden Anschlusselemente des Trägerelements mit Kunstharz benetzt werden und damit ihre Lötbarkeit beeinträchtigt wird.

Der vorliegenden Erfindung liegt die Aufgabe zugrunde, eine Möglichkeit aufzuzeigen, durch welche bei ansonsten staub- und feuchtigkeitsdichtem Verschluss des Bauteils die Benetzung der nach aussen gekehrten Abschnitte der Anschlusselemente vermieden wird.

Für in einen Becher eingesetzte elektrische Bauelemente, Bauelementegruppen oder integrierte Schaltungen, insbesondere elektrische OFW-Filter, mit zur Becheraussenseite gekehrten elektrischen und mechanischen Anschlusselementen, die abschnittsweise in einem als Becherverschluss wirkenden Kunststoffteil gehalten sind, dessen zum Becher gekehrte Flächen mittels thermoplastischem Kunststoff staub- und feuchtigkeitsdicht mit dem Becher verbunden sind, sieht die Erfindung zur Lösung der gestellten Aufgabe vor, dass als thermoplastischer Kunststoff eine Kunststoffschicht, bestehend aus Heisskleber, vorgesehen ist, die zusätzlich die nach aussen gekehrte Stirnfläche des Kunststoffteils bedeckt und die Fuge zwischen Kunststoffteil und Becher sowie gegebenenfalls vorhandene Kanäle längs der Durchführungen der Anschlusselemente durch das Kunststoffteil staub- und feuchtigkeitsdicht schliesst.

Auf diese Weise entsteht eine dichte und mechanisch feste Verbindung zwischen Trägerelement und Becher, durch welche das elektronische Bauteil gegen Staub und klimabedingte Einflüsse z.B. Feuchtigkeit, weitgehend geschützt ist.

Als Material für den Becher und das Kunststoffteil eignen sich duroplastisches und thermoplastisches Material. Im letztgenannten Fall ist jedoch darauf zu achten, dass das Material einen Schmelzpunkt besitzt, der höher ist als der Schmelzpunkt der thermoplastischen Kunststoffschicht.

Zur Herstellung des einwandfreien Verschlusses ist vorteilhafterweise vorgesehen, dass das wenigstens teilweise mit einer thermoplastischen Schicht umspritzte Kunststoffteil in die Becheröffnung eingesetzt und anschliessend der Becher samt Kunststoffteil kurzzeitig etwa auf den Schmelzpunkt der thermoplastischen Schicht erwärmt wird, so dass diese zu fliessen beginnt und die Fuge zwischen Kunststoffteil und Becher ausfüllt, sowie gegebenenfalls vorhandene Kanäle längs der Durchführungen der Anschlusselemente durch das Kunststoffteil staub- und feuchtigkeitsdicht schliesst.

Zweckmässigerweise werden der Becher und das eingesetzte Kunststoffteil bei einigen Graden unterhalb des Schmelzpunktes der thermoplastischen Schicht vorerwärmt und anschliessend kurzzeitig bis über den Schmelzpunkt der thermoplastischen Schicht erwärmt. Dies kann mittels Infrarotstrahlung, Mikrowellenstrahlung oder ähnlichem erfolgen.

Die Erfindung wird nachstehend anhand eines Ausführungsbeispieles näher erläutert. Es zeigt:

Fig. 1 eine erste Seitenansicht des OFW-Filters in schematischer Darstellung,

Fig. 2 eine zweite Seitenansicht des OFW-Filters nach Fig. 1, in teilweise geschnittener Darstellung,

Fig. 3 ein in einen Becher eingesetztes OFW-Filter nach Fig. 1 und 2,

Fig. 4 den Becher samt OFW-Filter gem. Fig. 3 in teilweise geschnittener Seitenansicht.

Das dargestellte Filter besitzt ein Trägerelement 5, insbesondere aus Kupfer, das eine tiefgezogene Chipwanne aufweist. In der Chipwanne ist ein mittels Kleber 6 befestigtes OFW-Chip 2 angeordnet, das über Drähte oder Bändchen 4 mit den einen Enden von Anschlusselementen 3 kontaktiert ist. Die Anschlusselemente 3 samt Trägerelement 5 sind in einem Kunststoffteil 7 gehalten.

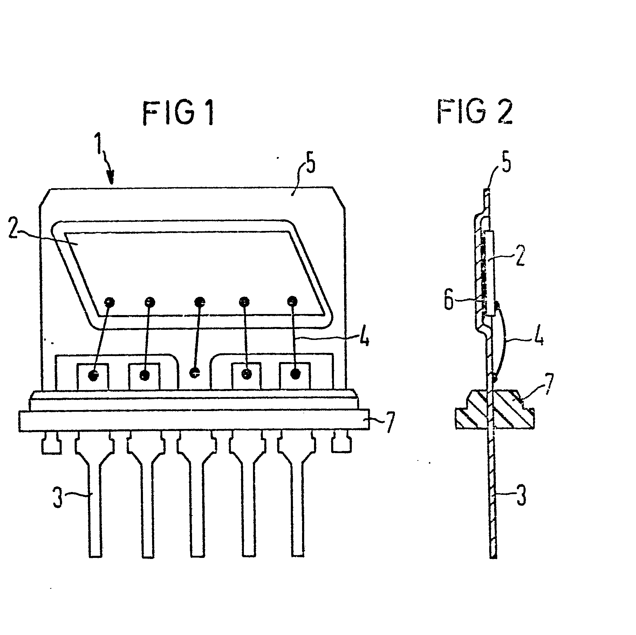

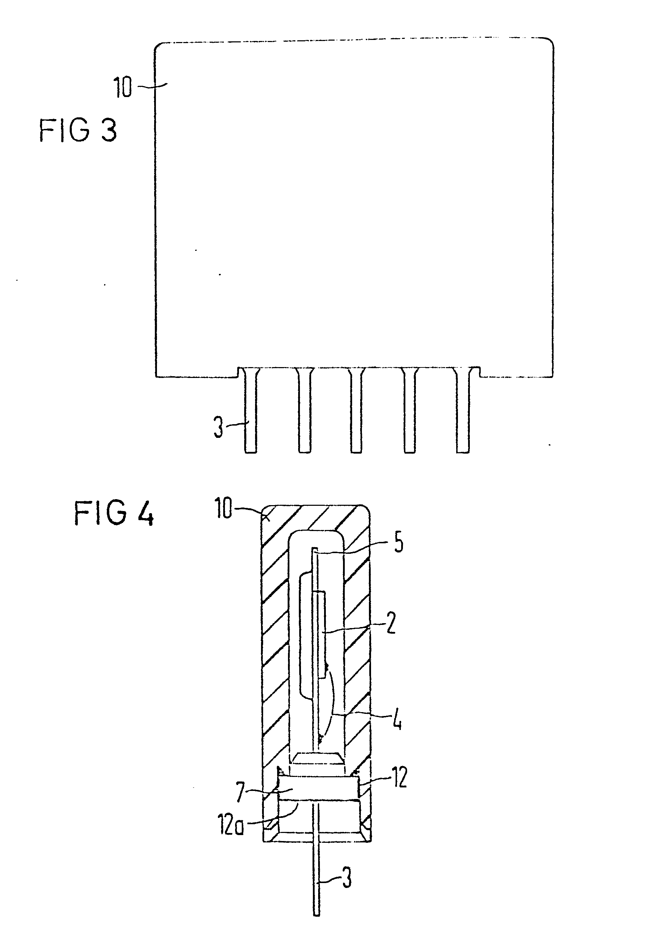

Gemäss Fig. 3, 4 ist das in Fig. 1, 2 gezeigte OFW-Filter in einen Becher 10 eingesetzt. Das Kunststoffteil 7 ist dabei über eine thermoplastische Schicht 12 mit den zugekehrten Flächen des Bechers 10 verbunden. Zur Gewährleistung eines einwandfreien staub- und feuchtigkeitsdichten Verschlusses ist zusätzlich die nach aussen gekehrte Stirnfläche des Kunststoffteils 7 mit einer thermoplastischen Schicht bedeckt, so dass ev. bestehende Kanäle längs der Anschlusselemente 3 staub- und feuchtigkeitsdicht geschlossen sind.

## Patentansprüche

1. In einen Becher (10) eingesetztes elektrisches Bauelement, Bauelementegruppe oder integrierte Schaltung, insbesondere elektrisches OFW-Filter, mit zur Becheraussenseite gekehrten elektrischen und mechanischen Anschlusselementen (3), die abschnittsweise in einem als Becherverschluss wirkenden Kunststoffteil (7) gehalten sind, dessen zum Becher (10) gekehrte Flächen mittels thermoplastischem Kunststoff staub- und feuchtigkeitsdicht mit dem Becher (10) verbunden sind, dadurch gekennzeichnet, dass als thermoplastischer Kunststoff eine Kunststoffschicht (12), bestehend aus Heisskleber, vorgesehen ist, die zusätzlich die nach aussen gekehrte Stirnfläche des Kunststoffteils (7) bedeckt und die Fuge zwischen Kunststoffteil (7) und Becher (10) sowie gegebenenfalls vorhandene Kanäle längs der Durchführungen der Anschlusselemente (3) durch das Kunststoffteil (7) staub- und feuchtigkeitsdicht schliesst.

2. Elektrische Bauelemente, Bauelementegruppen oder integrierte Schaltungen, nach Anspruch 1, dadurch gekennzeichnet, dass der Becher (10) und das Kunststoffteil (7) aus duroplastischem Material bestehen.

3. Elektrische Bauelemente, Bauelementegruppen oder integrierte Schaltungen, nach Anspruch 1, dadurch gekennzeichnet, dass der Becher (10) und das Kunststoffteil (7) aus thermoplastischem Material bestehen, dessen Schmelzpunkt höher ist als der Schmelzpunkt der thermoplastischen Kunststoffschicht (12, 12a).

4. Verfahren zur Herstellung eines staub- und feuchtigkeitsdichten Verschlusses gemäss Anspruch 1 und einem der folgenden Ansprüche, dadurch gekennzeichnet, dass das wenigstens teilweise mit einer thermoplastischen Schicht (12) umspritzte Kunststoffteil (7) in die Becheröffnung eingesetzt und anschliessend der Becher samt Kunststoffteil kurzzeitig etwa auf den Schmelzpunkt der thermoplastischen Schicht erwärmt wird, so dass diese zu fliessen beginnt und die Fuge zwischen Kunststoffteil und Becher ausfüllt sowie gegebenenfalls vorhandene Kanäle längs der Durchführungen der Anschlusselemente (3) durch das Kunststoffteil (7) staub- und feuchtigkeitsdicht schliesst.

5. Verfahren nach Anspruch 4, dadurch gekennzeichnet, dass das Kunststoffteil (7) und der Becher (10) bei einigen Graden unterhalb des Schmelzpunktes der thermoplastischen Schicht (12, 12a) vorerwärmt und anschliessend kurzzeitig bis über den Schmelzpunkt der thermoplastischen Schicht (12, 12a) erwärmt werden.

## Claims

1. An electrical component, component group or integrated circuit, particularly an electrical ground wave filter, inserted in a cup (10) with electrical and mechanical connecting elements (3) facing the exterior of the cup, which are retained over a section in a synthetic resin part (7) which acts as a closure means for the cup, and the surfaces of which facing the cup (10) are connected in dust-tight and moisture-tight manner to the cup (10) by means of thermoplastic synthetic resin, characterised in that, as thermoplastic synthetic resin, a synthetic resin layer (12), consisting of a heat-sealing agent, is provided, which additionally covers the outward-facing end face of the synthetic resin part (7) and closes in dust-tight and moisture-tight manner the joint between the synthetic resin part (7) and the cup (10) as well as any channels which are present along the passages of the connecting elements (3) through the synthetic resin part (7).

2. Electrical components, component groups or integrated circuits according to Claim 1, characterised in that the cup (10) and the synthetic resin part (7) consist of thermosetting synthetic resin material.

3. Electrical components, component groups or integrated circuits according to Claim 1, characterised in that the cup (10) and the synthetic resin part (7) consist of thermoplastic material, the melting point of which is higher than the melting point of the thermoplastic synthetic resin layer (12, 12a).

4. A method of producing a dust-tight and moisture-tight closure according to Claim 1 and any of the following Claims, characterised in that the synthetic resin part (7), at least partially moulded into a thermoplastic layer (12), is inserted into the cup aperture, and the cup with the synthetic resin part is then heated briefly approximately to the melting point of the thermoplastic layer, so that the latter begins to flow and fills the joint between the synthetic resin part and the cup, and also closes in dust-tight and moisture-tight manner any channels which may be present along the passages of the connecting elements (3) through the synthetic resin part (7).

5. A method according to Claim 4, characterised in that the synthetic resin part (7) and the cup (10) are preheated a few degrees below the melting point of the thermoplastic layer (12, 12a) and are then briefly heated above the melting point of the thermoplastic layer (12, 12a).

## Revendications

1. Composant électrique, groupe de composants électriques ou circuit intégré, notamment filtre électrique à ondes de surface, inséré dans un boîtier (10) et comportant des organes électriques et mécaniques de raccordement (3) tournés vers le côté extérieur du boîtier et maintenus, par sections, dans une pièce en matière plastique (16) agissant en tant que dispositif de fermeture du boîtier et dont les surfaces tournées vers le boîtier (10) sont réunies à ce dernier d'une manière étanche à la poussière et à l'humidité, au moyen d'une matière thermoplastique, caractérisé par le fait qu'il est prévu comme matière thermoplastique, une couche de matière plastique (12), constituée par une colle thermosoudable qui recouvre en outre la surface frontale, tournée vers l'extérieur, de la pièce en matière plastique (7) et obture d'une manière étanche à la poussière et à l'humidité le joint entre la pièce en matière plastique (7) et le boîtier (10) ainsi que des canaux éventuellement présents le long des passages des organes de raccordement (3) à travers la pièce en matière plastique (7).

2. Composants électriques, groupes de composants électriques ou circuits intégrés suivant la revendication 1, caractérisés par le fait que le boîtier (10) et la pièce en matière plastique (7) sont réalisés en un matériau thermodurcissable.

3. Composants électriques, groupes de composants électriques ou circuits intégrés suivant la revendication 1, caractérisés par le fait que le boîtier (10) et la pièce en matière plastique (7) sont réalisés en un matériau thermoplastique, dont le point de fusion est supérieur au point de fusion de la couche de matériau thermoplastique (12, 12a).

4. Procédé pour fabriquer un système de fermeture étanche à la poussière et à l'humidité selon la revendication 1 et l'une des revendications suivantes, caractérisé par le fait qu'on introduit la pièce en matière plastique (7), enrobée au moins partiellement par moulage par injection avec une couche thermoplastique (12), dans l'ouverture du boîtier et qu'on chauffe ensuite le boîtier ainsi que la pièce en matière plastique pendant un bref intervalle de temps approximativement à la température du point de fusion de la couche thermoplastique de sorte que cette dernière commence à fluer et remplit le joint présent entre la pièce en matière plastique et le boîtier et ferme d'une manière étanche à la poussière et à l'humidité des canaux éventuellement présents le long des traversées des organes de raccordement (3) traversant la pièce en matière plastique (7).

5. Procédé selon la revendication 4, caractérisé par le fait qu'on chauffe préalablement la pièce en matière plastique (7) et le boîtier (6) à quelques degrés au-dessous du point de fusion de la couche thermoplastique (12, 12a) et qu'on chauffe ensuite ces éléments pendant un bref intervalle de temps jusqu'à une température supérieure au point de fusion de la couche thermoplastique (12, 12a).

FIG 1

FIG 2

FIG 3

FIG 4